# EUROPÄISCHE PATENTSCHRIFT

(11) **EP 0 511 524 B1**
(45) Veröffentlichungstag und Bekanntmachung des Hinweises auf die Patenterteilung: **13.11.1996**
(21) Anmeldenummer: 92106019.0
(22) Anmeldetag: 07.04.1992
(51) Int. Cl.: H03K 17/62

(54) **Schaltungsanordnung zum Schalten von Analogsignalen auf eine Ausgangsklemme**
Circuit arrangement for switching analog signals to an output terminal
Montage servant à commuter des signaux analogiques vers une borne de sortie

(30) Priorität: 30.04.1991 DE 4114201; 30.04.1991 DE 9105356 U
(43) Veröffentlichungstag der Anmeldung: 04.11.1992
(73) Patentinhaber: SIEMENS AKTIENGESELLSCHAFT, 80333 München (DE)
(72) Erfinder: Heymann, Roland, Dipl.-Ing., W-8029 Sauerlach (DE)

(56) Entgegenhaltungen:
- DE-A- 3 003 792
- US-A- 3 454 893
- US-A- 4 835 771
- PATENT ABSTRACTS OF JAPAN vol. 9, no. 110 (E-314)(1833) 15. Mai 1985

## Beschreibung

Die Erfindung bezieht sich auf eine Schaltungsanordnung zum Schalten einer Anzahl von Analogsignalen auf eine Ausgangsklemme mit einer Anzahl von Eingangsklemmen zum Anlegen jeweils eines der Analogsignale, und jeweils einen ersten und einen zweiten Transistor aufweisende Differenzverstärker, wobei bei jedem Differenzverstärker jeweils ein Emitteranschluß jedes dieser zwei Transistoren über eine gemeinsame Stromquelle mit einem Bezugspotential verbunden ist, ein Basisanschluß des jeweils ersten Transistors mit jeweils einer der Eingangsklemmen verbunden ist, ein Kollektoranschluß des jeweils ersten Transistors auf ein positives Potential geschaltet ist, ein Basisanschluß des jeweils zweiten Transistors mit der Ausgangsklemme verbunden ist, und ein Kollektoranschluß des zweiten Transistors über eine weitere Stromquelle oder einen Widerstand auf das positive Potential geschaltet ist.

Eine solche Schaltungsanordnung ist beispielsweise aus der DE-PS 30 03 792 bekannt. Dort ist außerdem der Ausgang der Schaltungsanordnung mit dem Emitter eines Transistors verbunden, dessen Kollektor mit dem positiven Potential und dessen Basis mit den Kollektoren der zweiten Transistoren der Differenzverstärker verbunden ist. Die Kollektoren der zweiten Transitoren sind über einen Widerstand mit dem positiven Potential verbunden.

Auch die US-PS 4,835,771 beschreibt eine solche Schaltungsanordnung zum Schalten einer Anzahl von Analogsignalen auf eine Ausgangsklemme. Bei dieser Schaltungsanordnung sind die zweiten Transistoren der Differenzverstärker durch einen Multi-Emitter-Transistor realisiert, dessen Basisanschluß mit dem Kollektoranschluß und der Ausgangsklemme verbunden und über einen Widerstand auf positives Potential geschaltet ist.

Weitere Beispiele von Analogschaltern sind auch im Buch "Schaltungstechnik" von Tietze und Schenk, 5. Auflage, 1980, auf den Seiten 397 bis 407 beschrieben. In Kapitel 17.3.3 dieses Buches wird ein Analogschalter vorgestellt, der zwei parallel geschaltete Differenzverstärker mit Bipolartransistoren aufweist und bei dem der Emitterstrom von einem zum anderen Differenzverstärker umschaltbar ist. Bei geeigneter Dimensionierung kann man mit einem solchen Analogschalter Bandbreiten bis über 100 MHz erreichen. Die Schaltung eignet sich deshalb für den Einsatz in der Nachrichtentechnik als Modulator, Demodulator oder Phasendetektor sowie als Kanalumschalter im Breitbandoszillographen.

Prinzipiell sollten solche Analogschalter eine möglichst gute Übersprechdämpfung über einen großen Frequenzbereich aufweisen. Unter Übersprechen ist dabei die Fähigkeit eines Analogsignales zu verstehen, auf das andere Analogsignal störend einzuwirken. Darüber hinaus sollten Analogschalter im gesperrten Zustand eine hohe Isolationsspannung aufweisen. Das Erfüllen dieser Erfordernisse ist z. B. besonders wichtig bei in Satelliten übertragenen breitbandigen Videosignalen, die eine Bandbreite von bis zu 12 MHz aufweisen.

Bei den oben erwähnten bekannten Analogschaltern hat sich herausgestellt, daß bei den parallelgeschalteten Differenzverstärkern noch hohe Sperrschichtkapazitäten wirksam bleiben, die beim Schalten von Videosignalen, die über Satelliten übertragen werden, störend in Erscheinung treten.

Der Erfindung liegt deshalb die Aufgabe zugrunde, einen Analogschalter anzugeben, der einerseits eine hohe Ubersprechdämpfung über einen großen Frequenzbereich und einen hohen Eingangswiderstand aufweist. Darüber hinaus soll sich der Analogschalter durch einen niedrigen Stromverbrauch und einen niedrigen Ausgangswiderstand auszeichnen.

Diese Aufgabe wird durch einen Analogschalter mit den Merkmalen des Anspruchs 1 gelöst.

Weiterbildungen der Erfindung sind Gegenstand der Unteransprüche.

Die Erfindung wird im folgenden anhand von zwei Figuren näher erläutert. Es zeigen:
- FIG 1: ein Prinzipschaltbild einer erfindungsgemäßen Schaltungsanordnung zum Schalten von zwei Analogsignalen auf eine Ausgangsklemme und
- FIG 2: ein Ausführungsbeispiel einer Schaltungsanordnung zum Schalten von n Analogsignalen, wie sie in einem Satellitenvideoprozessor verwendbar ist.

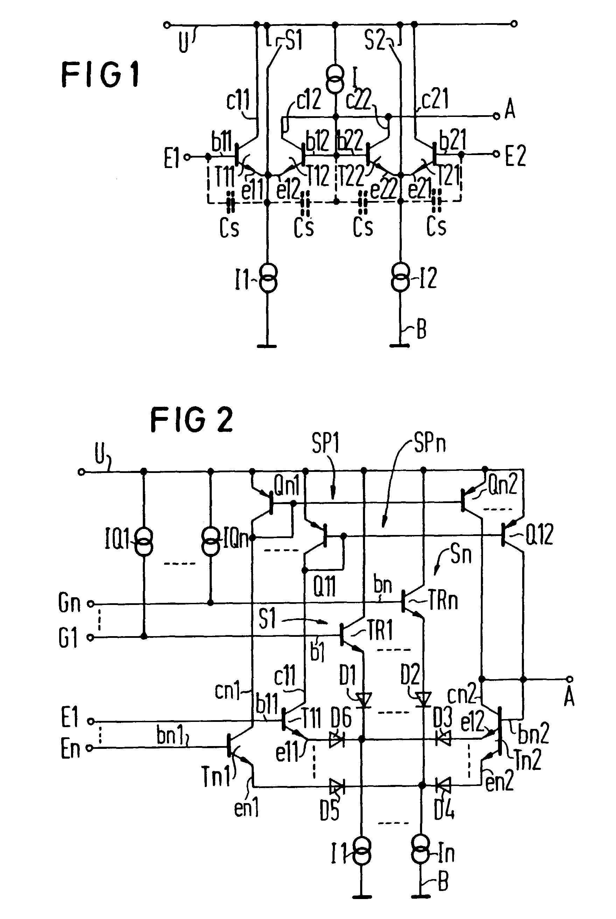

FIG 1 zeigt das Prinzipschaltbild der erfindungsgemäßen Schaltungsanordnung zum Schalten von zwei Analogsignalen auf eine Ausgangsklemme A. Dazu weist die Schaltungsanordnung zwei Eingangsklemmen E1, E2 zum Anlegen eines ersten und eines zweiten Analogsignales auf sowie zwei jeweils einen ersten und zweiten npn-Transistor T11, T12, T21, T22 beinhaltende Differenzverstärker. Bei jedem dieser Differenzverstärker sind die Emitteranschlüsse e11, e12, e21, e22 der jeweils zusammengehörenden Transistoren T11, T12 sowie T21, T22 über eine gemeinsame Stromquelle I1, I2 mit einem Bezugspotential B, hier ein Masseanschluß verbunden. Ein Basisanschluß b11 des ersten Transistors T11 des ersten Differenzverstärkers ist mit der ersten Eingangsklemme E1 und ein Basisanschluß b21 des ersten Transistors T21 des zweiten Differenzverstärkers mit der zweiten Eingangsklemme E2 der Schaltungsanordnung verbunden. Die Kollektoranschlüsse c11, c21 der jeweils ersten Transistoren T11, T21 sind an ein positives Potential, hier eine positive Versorgungsspannung U, angeschlossen.

Ein Basisanschluß b12 des zweiten Transistors T12 des ersten Differenzverstärkers ist mit einem Kollektoranschluß c12 dieses zweiten Transistors T12 kurzgeschlossen und mit der Ausgangsklemme A verbunden. Außerdem ist diese Ausgangsklemme A über eine weitere Stromquelle I auf das positive Potential U geschaltet. Der zweite Transistors T22 des zweiten Differenzverstärkers ist in gleicher Weise verschaltet. Dazu ist ein Basisanschluß b22 dieses zweiten Transistors T22 mit einem Kollektoranschluß c22 dieses zweiten Transistors T22 in Verbindung als auch an die Ausgangsklemme A angeschlossen. Über die Stromquelle I liegt der Kollektoranschluß c22 und der Basisanschluß b22 dieses zweiten Transistors T22 des zweiten Differenzverstärkers auch auf positivem Potential U.

Bisher entspricht die beschriebene Schaltungsanordnung von FIG 1 der eingangs erwähnten bekannten Schaltungsanordnung eines Analogschalters, wenn die gemeinsamen Stromquellen I1, I2 geschaltet betrieben werden. Soll beispielsweise das erste Analogsignal an der Eingangsklemme E1 an die Ausgangsklemme A geleitet werden, so muß die Stromquelle I1 eingeschaltet und die Stromquelle I2 ausgeschaltet sein. Soll dagegen das Analogsignal an der Eingangsklemme E2 an die Ausgangsklemme A der Schaltungsanordnung gelangen, muß die Stromquelle I1 ausgeschaltet und die Stromquelle I2 eingeschaltet werden. Damit bleiben aber im abgeschalteten Zustand noch große Sperrschichtkapazitäten, die in FIG 1 als Cs bezeichnet sind und zwischen den Basisanschlüssen und Emitteranschlüssen der jeweiligen Transistoren liegen, wirksam. Diese Sperrschichtkapazitäten Cs verschlechtern die Übersprechdämpfung bei hohen Frequenzen.

Bei der erfindungsgemäßen Schaltungsanordnung von FIG 1 werden dagegen die Stromquellen I1 und I2 nicht selbst abgeschaltet, sondern deren Strom über eine Schalteinrichtung an das positive Potential abgeleitet. Dazu weist die Schaltungsanordnung eine erste Schalteinrichtung S1 auf, die zwischen positives Potential U und einem Anschluß der ersten gemeinsamen Stromquelle I1 geschaltet, der nicht mit dem Bezugspotential B verbunden ist. In gleicher Weise liegt eine zweite Schalteinrichtung S2 zwischen positivem Potential U und einem Anschluß der zweiten gemeinsamen Stromquelle I2, der ebenfalls nicht mit dem Bezugspotential B in Verbindung steht. Wird eine dieser beiden Schalteinrichtungen S1, S2 geschlossen, so fließt der Strom der jeweils dazugehörenden Stromquellen I1, I2 an positives Potential U ab. Durch diese erfindungsgemäße Anordnung ergeben sich folgende Vorteile:
- ein hoher Eingangswiderstand der Schaltungsanordnung,
- ein niederohmiger Ausgangswiderstand im Einschaltzustand,
- eine hohe Sperrspannung an den Basis-Emitter-Diodenstrecken der Transistoren T11, T12 des ersten Differenzverstärkers sowie der Transistoren T21, T22 des zweiten Differenzverstärkers und damit eine geringe Sperrschichtkapazität im abgeschalteten Zustand.

Durch die erfindungsgemäße Schaltungsanordnung in FIG 1 wird der Verbindungspunkt der Emitteranschlüsse e11, e12 bzw. der Emitteranschlüsse e21, e22 der Transistoren T21, T22 des zweiten Differenzverstärkers und damit auch die Sperrschichtenkapazitäten Cs über die Schalteinrichtung S1 bzw. S2 direkt mit dem positiven Potential U kurzgeschlossen, wodurch die Sperrschichtenkapazitäten Cs für hohe Frequenzen keine Verkopplung der Eingänge E1, E2 mit dem Ausgang A verursachen. Mit einer entsprechenden Zuleitungsführung lassen sich bei Eingangssignalen von etwa 10 MHz Übersprechdämpfungen von > 60 dB erreichen.

In FIG 2 ist ein Ausführungsbeispiel einer erfindungsgemäßen Schaltungsanordnung dargestellt, wie sie beispielsweise in einem integrierten Schaltkreis eines Videoprozessors zum Empfang von Satellitenvideosignalen verwendet werden kann. Gleiche Bezugszeichen wie in FIG 1 bezeichnen gleiche Teile. Wie bereits aus FIG 1 ersichtlich, liegt zwischen einer Eingangsklemme und der Ausgangsklemme A jeweils ein identischer Schaltungsteil, um ein Analogsignal an den Ausgang A zu schalten. Dementsprechend wurde die Darstellung von FIG 2 vereinfacht. Es ist nur derjenige Schaltungsteil dargestellt wurde, der nach einer ersten Eingangsklemme E1 und nach eine n-ten Eingangsklemme En erfindungsgemäß notwendig ist. Die dazwischenliegenden Schaltungsteile wurden nur durch punktierte Linien angedeutet.

Die Schaltungsanordnung von FIG 2 weist also eine erste Eingangsklemme E1 auf, die mit dem Basisanschluß b11 des ersten Transistors T11 des ersten Differenzverstärkers verbunden ist. Dieser Transistor T11 ist an seinem Emitteranschluß e11 über eine Diode D6 an die gemeinsame Stromquelle I1 des ersten Differenzverstärkers angeschlossen. Diese gemeinsame Stromquelle I1 liegt zwischen dem Katodenanschluß dieser Diode D6 und einem Bezugspotential B, das auf Masse geschaltet ist. Der Verbindungspunkt zwischen der Diode D6 und der ersten gemeinsamen Stromquelle I1 ist zugleich an einen Katodenanschluß einer weiteren Diode D3 angeschlossen, deren Anodenanschluß mit einem Emitteranschluß e12 eines zweiten Transistors Tn2 des ersten Differenzverstärkers verbunden ist. Ein Kollektoranschluß cn2 und ein Basisanschluß bn2 dieses zweiten Transistors Tn2 ist mit dem Ausgangsanschluß A der Schaltungsanordnung in Verbindung. Ein Kollektoranschluß c11 des ersten Transistors T11 ist mit dem Kollektoranschluß cn2 über eine Stromspiegelschaltung SP1 verbunden. Diese Stromspiegelschaltung besteht aus den Transistoren Q11 und Q12. Dazu ist der Transistor Q11 als pnp-Transistor ausgebildet, dessen Basisanschluß mit dessen Kollektoranschluß kurzgeschlossen und dessen Emitteranschluß an das positive Potential U geschaltet ist. Der Basisanschluß und Kollektoranschluß dieses Transistors Q11 ist mit dem Kollektoranschluß c11 des ersten Transistors T11 in Verbindung. Der zweite Transistor Q12, der ebenfalls ein pnp-Transistor ist, ist mit seinem Basisanschluß an den Basisanschluß des Transistors Q11 angeschlossen und mit seinem Kollektoranschluß mit dem Ausgangsanschluß A der Schaltungsanordnung in Verbindung. Der Emitteranschluß dieses Transistors Q12 liegt auf positivem Potential U.

Erfindungsgemäß weist die Schaltungsanordnung von FIG 2 noch eine Schalteinrichtung zum Ableiten des Stromes der gemeinsamen Stromquelle I1 an positives Potential auf. Dazu ist jetzt eine Schalteinrichtung vorgesehen, die einen Transistor TR1 aufweist, dessen Laststrecke zwischen das positive Potential U und einem nicht mit dem Bezugspotential B verbundenen Anschluß der gemeinsamen Stromquelle I1 geschaltet ist. Zwischen den Emitteranschluß dieses Transistors TR1 und der gemeinsamen Stromquelle I1 ist wieder eine Diode D1 so geschaltet, daß deren Kathodenanschluß mit der gemeinsamen Stromquelle I1 in Verbindung steht. Gesteuert wird diese Schalteinrichtung durch ein Steuersignal G1, das an den Basisanschluß des Transistors TR1 anzulegen ist. Zusätzlich weist die Schaltungsanordnung von FIG 2 eine zwischen das positive Potential U und den Basisanschluß des Transistors TR1 der Schalteinrichtung geschaltete Stromquelle IQ1 auf.

Je nach dem zwischen wievielen Analogsignalen in der Schaltungsanordnung umgeschaltet werden soll, wird die bis jetzt beschriebene Schaltungsanordnung vervielfacht. In FIG 2 ist dies andeutungsweise durch eine weitere Schaltungsanordnung gleicher Art dargestellt, die zwischen die Eingangsklemme En und der Ausgangsklemme A geschaltet ist. Der Differenzverstärker weist dazu die Transistoren Tn1, Tn2 mit den Dioden D5 und D4 auf, wobei als gemeinsame Stromquelle die Stromquelle In dient. Als Stromspiegel SPn dienen die Transistoren Qn1 und Qn2. Die Schalteinrichtung wird durch den Transistor TRn und die Diode D2 gebildet, die durch das Steuersignal Gn steuerbar ist. Zusätzlich ist eine Stromquelle IQn vorgesehen.

Wie in FIG 2 dargestellt, ist als zweiter Transistor in den Differenzverstärken ein Multiemittertransistor Tn2, der einen gemeinsamen Basisanschluß bn2, einen gemeinsamen Kollektoranschluß cn2 sowie eine Vielzahl von Emitteranschlüssen e12, ...en2 aufweist, vorgesehen. Als Transistoren dienen in der erfindungsgemäßen Schaltungsanordnung Bipolartransistoren.

Die Dioden D1, D2, D3, D4, D5, D6 dienen zur Erhöhung der Isolationsspannung der erfindungsgemäßen Schaltungsanordnung.

## Patentansprüche

1. Schaltungsanordnung zum Schalten von n Analogsignalen auf eine Ausgangsklemme (A) mit
- n Eingangsklemmen (E1;...;En) zum Anlegen jeweils eines der Analogsignale, und
- n jeweils einen ersten und einen zweiten Transistor (T11, T12;...;Tn1, Tn2) aufweisende Differenzverstärker, wobei bei jedem Differenzverstärker
- jeweils ein Emitteranschluß (e11, e12;...;en1, en2) jedes dieser zwei Transistoren (T11, T12;...;Tn1, Tn2) über eine gemeinsame Stromquelle (I1;...;In) mit einem Bezugspotential (B) verbunden ist,
- ein Basisanschluß (b11;...; bn1) des jeweils ersten Transistors T11;...;Tn1) mit jeweils einer der n Eingangsklemmen (E1;...;En) verbunden ist,
- ein Kollektoranschluß (c11;...;cn1) des jeweils ersten Transistors (T11;...;Tn1) auf ein positives Potential (U) geschaltet ist,
- ein Basisanschluß (b12;...;bn2) des jeweils zweiten Transistors (T12;...;Tn2) mit einem Kollektoranschluß (c12;...;cn2) des zweiten Transistors (T12;...;Tn2) kurzgeschlossen und mit der Ausgangsklemme (A) verbunden sowie über eine weitere Stromquelle (I) auf das positive Potential geschaltet ist, und
- eine Schalteinrichtung (S1;...;Sn) zum Ableiten des Stromes der jeweils gemeinsamen Stromquelle (I1;...;In) an das positive Potential (U) vorgesehen ist, wobei die Schalteinrichtung zum Kurzschließen des nicht mit dem Bezugspotential (B) verbundenen Anschlusses der gemeinsamen Stromquelle (I1; ...;In) mit dem positiven Potential (U) schaltbar ist.

2. Schaltungsanordnung nach Anspruch 1,
**dadurch gekennzeichnet,**
daß als Schalteinrichtung (S1;...;Sn) ein von einem Steuersignal (G1;..;Gn) an seinem Basisanschluß (b1;...;bn) beaufschlagbarer Transistor (TR1;...;TRn) vorgesehen ist, dessen Laststrecke zwischen dem positiven Potential (U) und dem nicht mit dem Bezugspotential (B) verbundenen Anschluß der gemeinsamen Stromquelle (I1;..;In) geschaltet ist.

3. Schaltungsanordnung nach Anspruch 1 oder 2, **dadurch gekennzeichnet,**
daß mindestens ein Teil der Transistoren (T11, T12;...;Tn1,
Tn2; TR1;...;TRn) an ihren Emitteranschlüssen (e11...en1) in Serie geschaltete Dioden (D) aufweisen.

4. Schaltungsanordnung nach einem der Ansprüche 1 bis 3, **dadurch gekennzeichnet,**
daß die zweiten Transistoren (T21;...;Tn2) als Multiemittertransistor
ausgebildet sind.

5. Schaltungsanordnung nach einem der Ansprüche 1 bis 4, **dadurch gekennzeichnet,**
daß zwischen den Kollektoranschlüssen (c11;...;cn1) der
jeweils ersten Transistoren (T11;...;Tn1) und Kollektoranschlüssen (c12;...;cn2) der jeweils zweiten Transistoren (T12;...;Tn2) ein Stromspiegel (SP1;...;SPn) angeordnet ist.

## Claims

1. Circuit arrangement for connecting n analogue signals to an output terminal (A) having
- n input terminals (E1;...; En) for application of in each case one of the analogue signals, and
- n differential amplifiers, which in each case have a first and a second transistor (T11, T12;...;Tn1, Tn2), for each differential amplifier
- in each case one emitter connection (e11, e12;...;en1, en2) of each of these two transistors (T11, T12;...;Tn1, Tn2) being connected via a common current source (I1;...;In) to a reference-earth potential (B),
- a base connection (b11;...;bn1) of the respective first transistor (T11;...;Tn1) being connected to in each case one of the n input terminals (E1;...;En),
- a collector connection (c11;...;cn1) of the respective first transistor (T11;...;Tn1) being connected to a positive potential (U),
- a base connection (b12;...;bn2) of the respective second transistor (T12;...;Tn2) being shorted to a collector connection (c12;...;cn2) of the second transistor (T12;...;Tn2) and being connected to the output terminal (A), as well as being connected via a further current source (I) to the positive potential, and
- a switching device (S1;...;Sn) being provided in order to dissipate the current from the respective common current source (I1;...;In) to the positive potential (U), the switching device being switchable in order to short the positive potential (U) to that connection of the common current source (I1;...;In) which is not connected to the reference-earth potential (B).

2. Circuit arrangement according to Claim 1, characterized in that a transistor (TR1;...;TRn) is provided as the switching device (S1;...;Sn), the base connection (b1;...;bn) of which transistor (TR1;...;TRn) can have a control signal (G1;..Gn) applied to it, and the load path of which transistor (TR1;...;TRn) is connected between the positive potential (U) and that connection of the common current source (I1;...;In) which is not connected to the reference-earth potential (B).

3. Circuit arrangement according to Claim 1 or 2, characterized in that at least some of the transistors (T11, T12;...;Tn1, Tn2; TR1;...;TRn) have diodes (D) which are connected in series with their emitter connections (e11...en1).

4. Circuit arrangement according to one of Claims 1 to 3, characterized in that the second transistors (T21;...;Tn2) are designed as a multi-emitter transistor.

5. Circuit arrangement according to one of Claims 1 to 4, characterized in that a balanced circuit (SP1;...;SPn) is arranged between the collector connections (c11;...;cn1) of the respective first transistors (T11;...;Tn1) and collector connections (c12;...;cn2) of the respective second transistors (T12;...;Tn2).

## Revendications

1. Montage de commutation de n signaux analogiques sur une borne A de sortie comportant
- n borne (E1 à En) d'entrée destinées chacune à l'application de l'un des signaux analogiques et
- n amplificateurs différentiels comportant chacun des premier et second transistors (T11, T12 à Tn1, Tn2), dans lequel dans chaque amplificateur de différence,
- une borne d'émetteur (e11, e12 à en1, en2) de chacun de ces deux transistors (T11, T12 à Tn1, Tn2) est reliée par l'intermédiaire d'une source (I1 à In) commune de courant à un potentiel (B) de référence,
- une borne (b11 à bn1) de base du premier transistor (T11 à Tn1) est reliée à l'une des n bornes (E1 à En) d'entrée,
- une borne (c11 à cn1) de collecteur du premier transistor (T11 à Tn1) est branchée à un potentiel (U) positif,
- une borne de base (b12 à bn2) du second transistor (T12 à Tn2) est court-circuitée à une borne de collecteur (c12 à cn2) du second transistor (T12 à Tn2), est reliée à la borne (A) de sortie et est branchée dans l'intermédiaire d'une autre source (I) de courant au potentiel positif,
- un dispositif (S1 à Sn) d'interruption destiné à dériver le courant de la source (I1 à In) commune de courant au potentiel positif (U) est prévu, le dispositif d'interruption destiné à court-circuiter la borne de la source (I1 à In) commune de courant qui n'est pas reliée au potentiel (B) de référence de potentiel positif (U) pouvant être branché au potentiel (U) positif.

2. Montage suivant la revendication 1,
caractérisé en ce que
il est prévu en tant que dispositif (S1 à Sn) d'interruption un transistor (TR1 à TRn), à la borne (b1 à bn) de base duquel est appliqué un signal (G1 à Gn) de commande et dont la voie de charge est branchée entre le potentiel positif (U) et la borne de la source (I1 à In) commune de courant qui n'est pas branchée au potentiel (B) de référence.

3. Montage suivant la revendication 1 ou 2,
caractérisé en ce que
au moins une partie des transistors (T11, T12 à Tn1, Tn2 ; TR1 à TRn) comportent à leurs bornes d'émetteur (e11 à en1) les diodes (D) branchées en série.

4. Montage suivant l'une des revendications 1 à 3,
caractérisé en ce que
les seconds transistors (T21 à Tn2) sont des transistors à émetteur multiple.

5. Montage suivant l'une des revendications 1 à 4,
caractérisé en ce que
il est disposé entre les bornes (c11 à cn1) de collecteur des premiers transistors (T11 à Tn1) et les bornes de collecteur (c12 à cn2) des seconds transistors (T12 à Tn2) un miroir de courant (SP1 à SPn).
